Europäisches Patentamt

European Patent Office

Office européen des brevets

Veröffentlichungsnummer: **0 287 886**
**A1**

# EUROPÄISCHE PATENTANMELDUNG

Anmeldenummer: **88105404.3**

Int. Cl.4: **G01R 19/00 , G01R 19/165**

Anmeldetag: **05.04.88**

Priorität: **08.04.87 AT 861/87**

Veröffentlichungstag der Anmeldung:
**26.10.88 Patentblatt 88/43**

Benannte Vertragsstaaten:
**AT DE FR GB**

Anmelder: **SIEMENS AKTIENGESELLSCHAFT
ÖSTERREICH
Siemensstrasse 88-92
A-1210 Wien(AT)**

**AT**

Anmelder: **SIEMENS AKTIENGESELLSCHAFT
Postfach 22 02 61
D-8000 München 22(DE)**

**DE FR GB**

Erfinder: **Winter, Kurt, Dipl.-Ing.
Salmgasse 7/6
A-1030 Wien(AT)**
Erfinder: **Jacopich, Werner
Pelzgasse 9/11
A-1150 Wien(AT)**
Erfinder: **Mayr, Siegfried
Tiefendorfergasse 13/32
A-1140 Wien(AT)**

**Schaltung zur Überwachung mehrerer analoger Grössen.**

Schaltung zur Überwachung mehrerer analoger Größen auf Überschreitung zugeordneter Grenzwerte mit Hilfe eines die Grenzwertüberschreitung signalisierenden Differenzverstärkers (V), von dem ein Eingang an eine Referenzspannungsquelle (U0) und der andere Eingang an einen Referenzwiderstand (R0) geschaltet ist. Die zu überwachenden Größen sind durch abbildende Spannungen (U1,U2)oder durch eingeprägte Ströme (J) repräsentiert, die über Entkopplungsdioden (D1,D2) sowie über Koppelwiderstände (R1,R2) in den mit dem Referenzwiderstand (R0) verbundenen Eingang des Differenzverstärkers eingespeist sind. Mehrere Koppelwiderstände (R1,R2) sind zusammen mit dem Referenzwiderstand (R0) zu einem einzigen Spannungsteiler vereinigt, in dessen Anzapfungen die abbildenden Spannungen (U1,U2) bzw. eingeprägten Ströme (J) gestaffelt nach den Größen den zugeordneten Grenzwerte eingespeist werden. Die Koppelwiderstände (R1,R2) sind so bemessen, daß die von den abbildenden Spannungen (U1,U2) bzw. eingeprägten Strömen (J) zwischen den zugeordneten Anzapfungen und dem Massepotential hervorgerufenen Spannungsabfälle (U'1,U'2) sich zur Referenzspannung (U0) so verhalten wie die von den betreffenden Anzapfungen zum Masseanschluß gemessenen Teilwiderständewerte zum Widerstandswert des Referenzwiderstandes (R0).

FIG 3

## Schaltung zur Überwachung mehrerer analoger Größen

Die Erfindung betrifft eine Schaltung zur Überwachung mehrerer analoger Größen auf Überschreitung zugeordneter Grenzwerte mit Hilfe eines die Grenzwertüberschreitungen signalisierenden Differenzverstärkers, wobei einerseits eine Referenzspannungsquelle zwischen Massepotential und einem Eingang des Differenzverstärkers und andererseits ein Referenzwiderstand zwischen Massepotential und dem anderen Eingang des Differenzverstärkers geschaltet ist, wobei die zu überwachenden Größen durch abbildende Spannungen oder durch eingeprägte Ströme repräsentiert sind, die über Entkopplungsdioden sowie über Koppelwiderstände in den mit dem Referenzwiderstand verbundenen Eingang des Differenzverstärkers eingespeist sind.

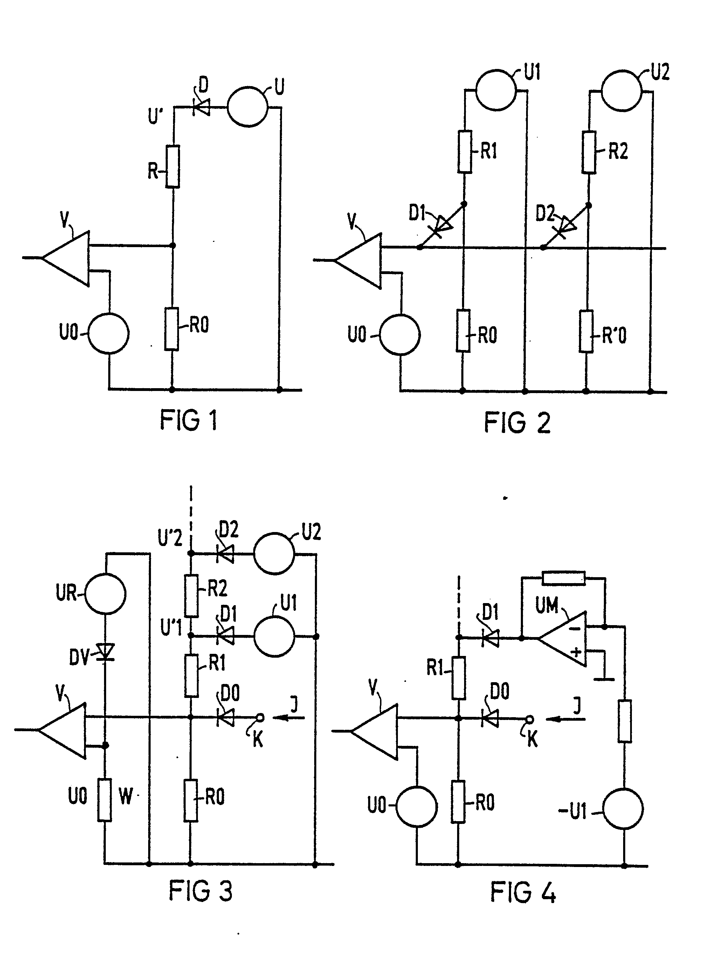

Das Prinzip, nach dem die Grenzwertüberwachung mittels Differenzverstärker erfolgt, ist im folgenden anhand der Fig. 1 der Zeichnung erläutert:

Die zu überwachende Größe wird durch eine Spannung U einer ebenso bezeichneten Spannungsquelle abgebildet, die über einen Koppelwiderstand R und betriebsbedingt über eine Diode D an der zusätzlich mit einem Referenzwiderstand R0 beschalteten Eingang eines Differenzverstärkers V angeschlossen ist. An den anderen Eingang des Differenzverstärkers V ist eine Referenzspannungsquelle U0 angeschlossen, die mit ihrem zweiten Pol ebenso wie der Referenzwiderstand R0 am Massepotential liegt. Der Koppelwiderstand R bildet zusammen mit dem Referenzwiderstand R0 einen Spannungsteiler, der von einer Spannung U' gespeist wird, die gleich der um den Spannungsabfall an der Diode D verringerten, die zu überwachende Größe abbildenden Spannung U ist. Sobald letztere den vorgesehenen Grenzwert überschreitet, erhöht sich auch der Span nungsabfall am Referenzwiderstand R0 über den vorgegebenen Wert der Referenzspannung U0, wodurch der Differenzverstärker V auf nicht näher dargestellte Weise die Grenzwertüberschreitung signalisiert.

In Geräten, in denen mehrere Einflußgrößen und Betriebswerte, die üblicherweise durch analoge Spannungen oder durch eingeprägte Ströme abgebildet werden, zu überwachen sind, wird meist für jede dieser Größen eine eigene Überwachungseinrichtung vorgesehen, was sich jedoch als sehr aufwendig erweist. Eine besondere Bedeutung hat dieses Problem bei Geräten, die ihre Funktion mittels mehrerer Versorgungsspannungen, Zwischenkreisspannungen, Ausgangsspannungen, analoger eingangs-und Ausgangssignale sowie ankommender und abgehender binärer Meldungen erfüllen, die auf Überschreitung von Grenzwerten bzw. Pegeln überwacht werden sollen.

Um bei der Überwachung mehrerer solcher Größen mit einem einzigen Differenzverstärker auskommen zu können, bedient man sich der in Fig. 2 dargestellten bekannten Schaltung:

Zwei (oder beliebig viele) auf Grenzwertüberschreitung zu überwachende Spannungen (bzw. Spannungsquellen) U1, U2 werden mit zugeordneten Spannungsteilern R1, R0 bzw. R2, R'0 versehen, deren Mittenanzapfungen über zugeordnete Entkopplungsdioden D1, D2 an einen Eingang des Differenzverstärkers V angeschlossen sind, wobei die Widerstände R0 bzw. R'0 als Referenzwiderstande dienen. Bei dieser Schaltung wird zwar mit einem einzigen Differenzverstärker V und mit einer einzigen Referenzspannung (bzw. Referenzspannungsquelle) U0 das Auslangen gefunden; es sind aber immer noch zwei Widerstände je zu überwachender Größe erforderlich.

Die Erfindung hat sich die Aufgabe gestellt, auch diesen Aufwand zu reduzieren und erzielt dies dadurch, daß mehrere Koppelwiderstände zusammen mit dem Referenzwiderstand zu einem einzigen Spannungsteiler vereinigt sind, in dessen Anzapfungen die abbildenden Spannungen bzw. eingeprägten Ströme gestaffelt nach den Größen der zugeordneten Grenzwerte eingespeist sind und daß die von den abbildenden Spannungen bzw. eingeprägten Strömen zwischen den zugeordneten Anzapfungen und dem Massepotential hervorgerufenen Spannungsabfälle (z.B. abbildende Spannung vermindert um dem Spannungsabfall an der zugehörigen Diode) sich zur Referenzspannung gleich verhalten wie die von den betreffenden Anzapfungen zum Masseanschluß gemessenen Teilwiderstandswerte zum Widerstandswert des Referenzwiderstandes.

Ausführungsbeispiele der Erfindung sind in den Fig. 3 und 4 der Zeichnung dargestellt.

Die in Fig. 3 gezeigte Schaltung dient der Überwachung von zwei abbildenden Spannungen U1, U2 sowie eines eingeprägten Stromes J einer hochohmigen Stromquelle. Diese nicht näher dargestellte, an die Klemme K angeschlossene Stromquelle sowie die Spannungsquellen U1, U2..., die die gleicherweise mit U1 und U2 bezeichneten Spannungen führen, sind über die zugeordneten Entkopplungsdioden D0, D1, D2... an die zugehörigen Anzapfungen eines einzigen, aus dem Referenzwiderstand R0 sowie den Koppelwiderständen R1, R2... bestehenden Spannungsteilers geschaltet. Die an den Anzapfungen wirkenden Spannungen sind mit U'1 und U'2 bezeichnet und sind gleich den um die Spannungsabfälle an die Entkopplungsdioden D1 bzw. D2 verminderten Spannungen U1 bzw. U2, die die entsprechenden zu überwachenden Größen abbilden. Die sonstige Wirkungsweise der Schaltung ist die gleiche wie die der in den Fig. 1 und 2 beschriebenen Schaltungen. Mittels eines noch mehr Teilwiderstände aufweisenden Spannungsteilers lassen sich praktisch beliebig viele Größen überwachen.

In Fig. 3 ist eine spezielle Schaltung zur Erzeugung der Referenzspannung U0 gezeigt, die im einzelnen aus einer Referenzspannungs quelle UR besteht, die über eine Vorschaltdiode DV einerseits an den einen Eingang des Differenzverstärkers V und anderseits über einen Widerstand W, an dem die Referenzspannung U0 liegt, an den Masseanschluß geschaltet ist.

In dem Fall, daß aus betriebsbedingten Gründen die die zu überwachende Größe abbildende Spannung zum Unterschied von den anderen abbildenden Spannungen negativ gegenüber dem Massepotential ist, dann ist, wie in Fig. 4 dargestellt, die entsprechende Spannungsquelle -U1 über ein Umkehrglied UM und die Entkopplungsdiode D1 an die zugeordnete Anzapfung des Spannungsteilers R0, R1... anzuschließen. Als Umkehrglied UM eignet sich ein rückgekoppelter, über seinen invertierenden Eingang angesteuerter Operationsverstärker.

## Ansprüche

Schaltung zur Überwachung mehrerer analoger Größen auf Überschreitung zugeordneter Grenzwerte mit Hilfe eines die Grenzwertüberschreitungen signalisierenden Differenzverstärkers, wobei einerseits eine Referenzspannungsquelle zwischen Massepotential und einem Eingang des Differenzverstärkers und anderseits ein Referenzwiderstand zwischen Massepotential und dem anderen Eingang des Differenzverstärkers geschaltet ist, wobei die zu überwachenden Größen durch abbildende Spannungen oder durch eingeprägte Ströme repräsentiert sind, die über Entkopplungsdioden sowie über Koppelwiderstände in den mit dem Referenzwiderstand verbundenen Eingang des Differenzverstärkers eingespeist sind, **dadurch gekennzeichnet,** daß mehrere Koppelwiderstände (R1,R2) zusammen mit dem Referenzwiderstand (R0) zu einem einzigen Spannungsteiler vereinigt sind, in dessen Anzapfungen die abbildenden Spannungen (U1, U2) bzw. eingeprägten Ströme (J) gestaffelt nach den Größen der zugeordneten Grenzwerte eingespeist sind und daß die von den abbildenden Spannungen (U1,U2) bzw. eingeprägten Strömen (J) zwischen den zugeordneten Anzapfungen und dem Massepotential hervorgerufenen Spannungsabfälle (U'1,U'2) (z.B. abbildende Spannung vermindert um den Spannungsabfall der zugehörigen Diode) sich zur Referenzspannung (U0) so verhalten wie die von den betreffenden Anzapfungen zum Masseanschluß gemessenen Teilwiderständewerte zum Widerstandswert des Referenzwiderstandes (R0).

FIG 1

FIG 2

FIG 3

FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | REGELUNGSTECHNIK, Band 8, Heft 10, Oktober 1960, Seiten 359-363, München, DE; P. PREISS: "Der Extremsucher, ein kontaktloses Extremwert- und Extremort-Auswahlgerät" * Seite 359, Spalte 2, Zeile 18 - Seite 360, Spalte 2, Zeile 4; Figuren 3,5 * --- | 1 | G 01 R 19/00 G 01 R 19/165 |
| A | FR-A-1 123 566 (PELLETIER) * Seite 2, Spalte 1, Zeile 9 - Spalte 2, Zeile 8; Figur 1 * --- | 1 | |
| A | DE-A-1 904 133 (SIEMENS AG) * Seite 2, Zeile 12 - Seite 3, Zeile 30; Figuren 1,2 * --- | 1 | |
| A | US-A-4 341 961 (KOMORIYA) * Spalte 3, Zeile 23 - Spalte 4, Zeile 15; Figur 1 * --- | 1 | |
| A | DE-C-3 305 626 (STANDARD ELEKTRIK LORENZ) * Spalte 2, Zeilen 55-65; Spalte 3, Zeile 35 - Spalte 4, Zeile 44; Figur * --- | 1 | **RECHERCHIERTE SACHGEBIETE (Int. Cl.4)** |
| A | EP-A-0 009 649 (SCHALTBAU GESELLSCHAFT) * Seite 3, Zeile 10 - Seite 5, Zeile 3; Figur * ----- | 1 | G 01 R 19/00 G 01 R 17/00 G 01 R 15/00 H 03 K 5/00 |

Der vorliegende Recherchenbericht wurde für alle Patentansprüche erstellt

| Recherchenort | Abschlußdatum der Recherche | Prüfer |
|---|---|---|
| DEN HAAG | 04-08-1988 | TRELEVEN C. |